(19) Europäisches Patentamt
European Patent Office
Office européen des brevets

(11) **EP 1 887 585 A1**

(12) **EUROPEAN PATENT APPLICATION**
published in accordance with Art. 153(4) EPC

(43) Date of publication:
**13.02.2008 Bulletin 2008/07**

(21) Application number: **06746757.1**

(22) Date of filing: **23.05.2006**

(51) Int Cl.:
*H01F 1/26* (2006.01)   *C22C 38/00* (2006.01)
*C22C 38/02* (2006.01)   *H01F 3/08* (2006.01)
*H01F 41/02* (2006.01)

(86) International application number:
**PCT/JP2006/310273**

(87) International publication number:
**WO 2006/126553 (30.11.2006 Gazette 2006/48)**

(84) Designated Contracting States:
**DE FR GB**

(30) Priority: **26.05.2005 JP 2005153808**

(71) Applicants:
• **Toyota Jidosha Kabushiki Kaisha**
**Aichi-ken, 471-0826 (JP)**
• **Kabushiki Kaisha Fine Sinter**
**Kawagoe-shi, Saitama, 3501165 (JP)**

(72) Inventors:
• **HATTORI, Takeshi,**
**c/o K.K. TOYOTA CHUO KENKYUSHO**
**Aichi-gun,**
**Aichi 4801192 (JP)**
• **TAJIMA, Shin,**
**c/o K.K. TOYOTA CHUO KENKENKYUSHO**
**Aichi-gun,**
**Aichi 4801192 (JP)**

• **SUGIYAMA, Masaki,**
**TOYOTA JIDOSHA KABUSHIKI KAISHA**
**Toyota-shi,**
**Aichi 4710826 (JP)**
• **KISHIMOTO Hidefumi**
**TOYOTA JIDOSHA KABUSHIKI KAISHA**
**Toyota-shi,**
**Aichi 4710826 (JP)**
• **YAMAGUCHI, Toshiya**
**TOYOTA JIDOSHA KABUSHIKI KAISHA**
**Toyota-shi,**
**Aichi 4710826 (JP)**
• **KIKKOU, Tadayoshi**
**c/o KABUSHIKI KAISHA FINE SINTER**
**Kasugai-shi,**
**Aichi 4860812 (JP)**

(74) Representative: **Smith, Samuel Leonard et al**
**J.A. Kemp & Co.,**
**14 South Square,**
**Gray's Inn**
**London WC1R 5JJ (GB)**

(54) **LOW MAGNETOSTRICTION BODY AND DUST CORE USING SAME**

(57)    [PROBLEM TO BE SOLVED] To provide an inexpensive low magnetostrictive body whose magnetostriction has been reduced alone while maintaining its magnetic properties such as loss and saturation magnetization at desired values; and a dust core using the same.

[SOLUTION] A low magnetostrictive body and a dust core using the same. The low magnetostrictive body obtained by adding, to a powder composed of a soft magnetic material, an organic compound having an effect of changing a magnetostriction of the soft magnetic material when used in combination with the soft magnetic material; pressing the resulting mixture into a green compact, and then heat treating the green compact in an inert atmosphere, wherein the absolute value of the magnetostriction $\lambda_{O-P}$ (1T/50Hz) is $1.0 \times 10^{-6}$ or less.

**EP 1 887 585 A1**

# FIG. 3

**Description**

TECHNICAL FIELD

The present invention relates to a low magnetostrictive body and dust core, more specifically, to a low magnetostrictive body generating markedly low magnetostriction when exposed to an alternating current magnetic field and a dust core using the same.

BACKGROUND ART

A dust core can be obtained by pressing powders composed of a soft magnetic material. It is used as a magnetic core of various electric appliances such as motor, transformer, DC solenoid actuator, inverter, switching device, and noise filter.

Magnetic properties of a dust core in a high frequency region depend on iron losses and the iron losses are mainly hysteresis loss and eddy current loss.

Of these, hysteresis loss is power loss generated by the domain wall pinning due to crystal defects, inclusions, internal stress or the like. The hysteresis loss must therefore be reduced by the removal of internal stress or the like as much as possible.

Eddy current loss, on the other hand, is power loss generated by the flow of an eddy current within a conductor placed in an alternating current magnetic field in a plane perpendicular to a magnetic flux. The eddy current loss must accordingly be reduced by increasing an electric resistivity of a dust core as much as possible.

It is therefore the common practice to use, as a starting raw material of a dust core, a soft magnetic powder having a surface covered with an electrical insulating resin or oxide in order to heighten the apparent electric resistivity. It is also the common practice to anneal the dust core, which has finished its pressing step, to remove a residual strain in order to reduce hysteresis loss.

An insulating film formed on the surface of a soft magnetic powder is however broken easily when the powder is pressed or heat treated. In particular, the insulating film is broken easily when the powder is pressed under high pressure in order to have a high density or the powder is treated at a relatively high temperature in order to remove the residual strain sufficiently. There have heretofore been many proposals for overcoming this problem.

For example, in Patent Document 1, there is disclosed a dust core obtained by mixing 4.0 wt% of a silicone resin with an Fe-Si alloy having an Si content of from 0.9 to 6.6 wt% and an O content of from 0.32 wt% or less, pressing the resulting mixture under pressure of 13 tonf/cm$^2$ (1274 MPa), and heat treating the resulting product at 800˚C for 1 hour in vacuum. It is described in this document that a dust core having less loss and high magnetic permeability can be obtained by optimizing the composition and form of the powder, and use of a silicone resin as both an insulating material and a binder enables suppression of the reduction of insulation properties during heating to high temperatures.

In Patent Document 2, there is disclosed a dust core obtained by covering the surface of an Fe-9.6 wt% Si-5.4 wt% Al alloy powder with 2 wt% of a silicone resin, covering the resulting surface further with 0.5 wt% of a zinc stearate lubricant, pressing the resulting powder under pressure of 13 tonf/cm$^2$ (1274 MPa), and heat treating the product for 1 hour at from 500 to 1000˚C in vacuum. In this document, it is described that a dust core having a high density and high magnetic permeability is available by the above-described method.

In Patent Document 3, there is disclosed a dust core obtained by adding 3 parts by weight of a silicone resin to an Fe-6.5 wt% Si alloy powder, pressing the resulting mixture under pressure of $1.27 \times 10^3$ MPa, impregnating the product with water glass, and heat treating the resulting product at 700˚C for 1 hour in vacuum. It is described in this document that impregnation of the product with a liquid insulation material such as water glass restores an electric insulating film which has been broken at the time of pressing, and raises the electric resistivity of the dust core by one or more orders of magnitude.

Patent Document 1: Japanese Patent Laid-Open No. 2000-30924
Patent Document 2: Japanese Patent Laid-Open No. 2000-223308
Patent Document 3: Japanese Patent Laid-Open No. 2002-64027

DISCLOSURE OF THE INVENTION

PROBLEMS TO BE SOLVED BY THE INVENTION

Magnetostriction is the phenomenon where a magnetic material changes its shape when it becomes magnetized. It is known that a soft magnetic material showing a magnetostriction phenomenon will be a cause for vibration or noise when it is used for a magnetic core of a transformer or reactor. A decrease in the operating magnetic flux density for reducing noise, on the other hand, results in an increase in the size of the magnetic core. It is therefore preferred to use a material exhibiting low magnetostriction for the magnetic core.

As a composition which is zero in each of magnetostrictions ($\lambda_{100}$, $\lambda_{111}$), so-called zero magnetostriction composition, Fe-Si compositions such as an Fe-6.5% Si composition and Fe-Si-Al (sendust) compositions such as an Fe-9.5% Si-5.7% Al composition are known.

A magnetic core using an Fe-6.5% Si steel plate, however, has the following drawbacks:

(1) It has low saturation magnetization (1.8T) owing to a large Si content.
(2) It is expensive (about 5 times as much as that of an ordinarily employed steel plate) because a special production process is used for it.
(3) It has poor formability owing to a large Si content.

Even if an Fe-6.5% Si alloy powder is used for the production of a dust core, the resulting dust core does not have a high density and must have further deteriorated saturation magnetization. The Fe-Si-Al alloy also has the same problem and its saturation magnetization is about 1T.

On the other hand, it is generally known that noise or vibration becomes smaller by the use of a dust core than by the use of a plate material having the same composition. According to the traditional recognition, however, vibration or noise is still large when the conventional dust core is used compared with that when a magnetic core made of an alloy exhibiting low magnetostriction is used.

A problem that the present invention is to solve is to provide a low magnetostrictive body having very low magnetostriction; and a dust core using the same.

Another problem that the present invention is to solve is to provide a low magnetostrictive body whose magnetostriction has been reduced alone while maintaining its magnetic properties such as loss and saturation magnetization at desired values; and a dust core using the same.

A further problem that the present invention is to solve is to provide a low magnetostrictive body which does not need a special production process and therefore can be produced at a low cost; and a dust core using the same.

MEANS FOR SOLVING THE PROBLEMS

The low magnetostrictive body of the present invention for overcoming the above-described problems is obtained by adding, to a powder composed of a soft magnetic material, an organic compound having an effect of changing the magnetostriction of a soft magnetic material when the organic compound is used in combination with the soft magnetic material; by pressing the resulting mixture and heat treating the green compact in an inert atmosphere; and has an absolute value of the magnetostriction $\lambda_{O-P}$ (1T/50Hz) not greater than $1.0 \times 10^{-6}$. The dust core according to the present invention comprises the low magnetostrictive body of the present invention.

EFFECT OF THE INVENTION

When a mixture of an organic compound (for example, a silicon-based resin) with a soft magnetic powder is formed into a green compact, followed by heat treatment, the magnetostriction increases/decreases by changing the amount of the organic compound. Use of the most suited kind or amount of the organic compound enables to reduce the absolute value of the magnetostriction to substantially zero irrespective of the composition of the soft magnetic powder. In addition, only a change in the amount of the organic compound enables a decrease in the magnetostriction alone so that a low magnetostrictive body having desired magnetic properties is available at a low cost.

BEST MODE FOR CARRYING OUT THE INVENTION

One embodiment of the present invention will hereinafter be described specifically.

The low magnetostrictive body according to the present invention can be obtained by adding an organic compound to a powder made of a soft magnetic material, pressing it into a green compact, and then heat treating the resulting green compact under an inert atmosphere.

The dust core according to the present invention comprises the low magnetostrictive body of the present invention.

No particular limitation is imposed on the composition of the powder used as a starting raw material in the present invention and various soft magnetic materials are usable. In particular, soft magnetic materials having Fe as a principal component have high magnetic properties so that they are suited as the starting raw material. The term "soft magnetic materials having Fe as a principal component" as used herein means metal materials having an Fe content of 90 wt% or greater.

Specific examples of the soft magnetic materials usable in the present invention include:

(1) pure iron,
(2) Fe-Si alloys containing from 0.5 to 3.5 wt% of Si,
(3) Fe-Al alloys containing from 1.0 to 3.0 wt% of A1, and
(4) Fe-Ni alloys.
Of these, Fe-Si alloys are relatively inexpensive and have high magnetic properties so that they are especially preferred as the starting raw material.

No particular limitation is imposed on the average particle size of the soft magnetic powder and it can be selected freely depending on the intended use. For example, when the low magnetostrictive body of the present invention is used as a dust core, a region through which an eddy current flows narrows with a decrease in the particle size of the soft magnetic powder so that an eddy current loss can be reduced. An increase in the particle size, on the other hand, facilitates the transfer of a magnetic domain wall and can therefore reduce a hysteresis loss. In order to obtain a dust core having a small iron loss, the soft magnetic powder has an average particle size of preferably 5 $\mu$m or greater but not greater than 500 $\mu$m, more preferably 20 $\mu$m or greater but not greater than 200 $\mu$m.
No particular limitation is imposed on the form of the soft magnetic powder and it may be a spherical powder such as gas atomized powder or an amorphous powder such as water atomized powder. In particular, in the case that an amorphous powder is used as the soft magnetic powder, a green compact having a high strength is available.

In general, the organic compounds can be roughly classified into:

(1) organic compounds A which do not change the magnetostriction regardless of their amount when used in combination with a powder made of a soft magnetic material,
(2) organic compounds B which have an effect of decreasing the magnetostriction of the soft magnetic material with an increase in their amount when used in combination with a powder made of a soft magnetic material, and
(3) organic compounds C which have an effect of increasing the magnetostriction of the soft magnetic material with an increase in their amount when used in combination with a powder made of a soft magnetic material.

In the present invention, organic compounds having an effect of changing the magnetostriction of the soft magnetic material (that is, the above-described organic compounds B or organic compounds C) are employed.
For example, when the soft magnetic material has positive magnetostriction properties, a low magnetostrictive body having substantially zero magnetostriction is available by use of the material in combination with the organic compound B.
For example, when the soft magnetic material has negative magnetostriction properties, a low magnetostrictive body having substantially zero magnetostriction is available by use of the material with the organic compound C.

Specific examples of the organic compound B include silicon-based resins and silicon-based surfactants..
Specific examples of the organic compound C include polyphenylene sulfide (PPS).
To which group, A, B or C the organic compound belongs can easily be found by studying - after adding the organic compound to the powder having positive or negative magnetostriction properties while varying its addition amount, pressing the resulting mixture into a green compact, and heat treating the green compact - the relationship between the magnetostriction of the green compact and the addition amount of the organic compound.
A silicon-based resin is especially suited as the organic compound for forming a low magnetostrictive body having low eddy current loss because it has an effect of decreasing the magnetostriction and at the same time, an insulating film is formed around the soft magnetic particles as a result of the heat treatment.

Most suited combination and mixing ratio of starting raw materials must be selected, depending on the particle size of the soft magnetic material, composition of the starting raw materials, properties which the low magnetostrictive body is required to have, and the like.
For example, an Fe-Si alloy containing $1 \pm 0.2$ wt% of Si is a soft magnetic material having positive magnetostriction properties so that the above-described organic compound B is used as the organic compound.
When the organic compound B is a silicon-based resin and an Fe-Si alloy powder has an average particle size of 20 $\mu$m or greater but not greater than 200 $\mu$m, the amount of the silicon-based resin is set at preferably 0.4 wt% or greater but not greater than 0.8 wt% in order to adjust the absolute value of the magnetostriction $\lambda_{O-P}$ (1T/50Hz) to $1 \times 10^{-6}$ or less. The amount of the silicon-based resin is preferably 0.5 wt% or greater but not greater than 0.7 wt% in order to adjust the absolute value of the magnetostriction $\lambda_{O-P}$ (1T/50Hz) to $0.5 \times 10^{-6}$ or less.

For example, an Fe-Si alloy containing $2 \pm 0.2$ wt% of Si is a soft magnetic material having positive magnetostriction properties so that the above-described organic compound B is used as the organic compound.
When the organic compound B is a silicon-based resin and an Fe-Si alloy powder has an average particle size of 20 $\mu$m or greater but not greater than 200 $\mu$m, the amount of the silicon-based resin is preferably 0.6 wt% or greater but not greater than 1.1 wt% in order to adjust the absolute value of the magnetostriction $\lambda_{O-P}$ (1T/50Hz) to $1 \times 10^{-6}$ or less.

The amount of the silicon-based resin is preferably 0.7 wt% or greater but not greater than 1.0 wt% in order to adjust the absolute value of the magnetostriction $\lambda_{O-P}$ (1T/50Hz) to $0.5 \times 10^{-6}$ or less.

For example, an Fe-Si alloy containing $3 \pm 0.2$ wt% of Si is a soft magnetic material having positive magnetostriction properties so that the above-described organic compound B is used as the organic compound.

When the organic compound B is a silicon-based resin and an Fe-Si alloy powder has an average particle size of 20 $\mu$m or greater but not greater than 200 $\mu$m, the amount of the silicon-based resin is preferably 0.7 wt% or greater but not greater than 1.3 wt% in order to adjust the absolute value of the magnetostriction $\lambda_{O-P}$ (1T/50Hz) to $1 \times 10^{-6}$ or less. The amount of the silicon-based resin is preferably 0.9 wt% or greater but not greater than 1.2 wt% in order to adjust the absolute value of the magnetostriction $\lambda_{O-P}$ (1T/50Hz) to $0.5 \times 10^{-6}$ or less.

The adding method of the organic compound to the soft magnetic material is not particular limited and the most suited one is employed, depending on the kind of the organic compound. A method usually employed is to dissolve the organic compound in a proper solvent (such as alcohol), add the soft magnetic powder to the resulting solution, and evaporate the solvent from the mixture.

The soft magnetic powder added with a predetermined amount of the organic compound is pressed under certain conditions. There are various methods for pressing a metal powder such as uniaxial pressing and hydrostatic pressing. In the present invention, any method is usable.

When the powder is pressed, a lubricant is usually employed for reducing powder-powder friction and/or powder-die friction. The lubricant may be mixed with the powder (internal addition) or may be applied to the surface of a die (external addition). Moreover, most suited conditions such as pressing temperature and pressing pressure are selected depending on the material of the powder, intended use of the pressed product, demanded properties, or the like.

Of these pressing methods, "die lubrication warm high-pressure forming method" is especially suited as a method for manufacturing a high-density green compact.

The term "die lubrication warm high-pressure forming method" as used herein means a method of applying a lubricant to the inner surface of a die without adding it to the powder and carrying out uniaxial pressing at a predetermined temperature (warm) at a predetermined pressure (high pressure).

As the lubricant used in the die lubrication warm high-pressure forming method, higher fatty acid lubricants and metal salts thereof are preferred. Specific examples of the higher fatty acid include stearic acid, palmitic acid and oleic acid.

Specific examples of the metal salts of the higher fatty acid include:

(1) lithium salts such as lithium stearate, lithium palmitate and lithium oleate,
(2) calcium salts such as calcium stearate, calcium palmitate and calcium oleate,
(3) zinc salts such as zinc stearate, and
(4) barium salts such as barium stearate.

Of these, lithium stearate, calcium stearate and zinc stearate are especially preferred as the lubricant for the die lubrication warm high-pressure forming method.

The lubricant is applied to a die by spraying an aqueous solution having the lubricant dispersed therein to the inner surface of a heated die by means of a spray gun, electrostatic gun or the like.

The amount of the lubricant in the aqueous solution is preferably 0.1 wt% or greater but not greater than 5 wt%. When the amount of the lubricant is less than 0.1 wt%, the lubrication effect is not sufficient. The amount of the lubricant exceeding 5 wt%, on the other hand, is not preferred, because an excess amount of the lubricant remains on the surface of the green compact. The amount of the lubricant is more preferably 0.5 wt% or greater but not greater than 2 wt%.

To the aqueous solution having the lubricant dispersed therein, a surfactant may be added. Addition of the surfactant enables more uniform dispersion of the lubricant. Specific examples of the surfactant include alkylphenol surfactants, polyoxyethylene nonylphenyl ether (EO) 6, polyoxyethylene nonylphenyl ether (EO) 10, anionic/nonionic surfactants and borate-based Emulbon T-80. Two or more of these surfactants may be used in combination.

When lithium stearate is used as the lubricant, simultaneous addition of three surfactants, that is, polyoxyethylene nonylphenyl ether (EO) 6, polyoxyethylene nonylphenyl ether (EO) 10 and borate based Emulbon T-80 improves the dispersibility of the lubricant compared with addition of any one of them thereto.

In order to obtain an aqueous solution having a viscosity suited for spraying, the amount of the surfactant to be added to the aqueous solution is preferably 1.5 vol% or greater but not greater than 15 vol%.

To the aqueous lubricant solution, a defoaming agent (for example, silicon-based defoaming agent) may be added further. Severe foaming of the aqueous solution makes it difficult to form a uniform film on the inner surface of the die. The amount of the defoaming agent in the aqueous solution is preferably 0.1 vol% or greater but not greater than 1 vol%.

The heating temperature of the die may be any temperature insofar as it permits the rapid evaporation of water from the lubricant solution sprayed to the inner surface of the die and the uniform formation of the lubricant film on the inner surface of the die. When the temperature of the die increases excessively, melting of the lubricant occurs, which disturbs formation of a uniform film. Accordingly, the heating temperature of the die is controlled to be less than the melting point of the lubricant (for example, 220°C when lithium stearate is used as the lubricant). The heating temperature of the die is preferably 100°C or greater but not greater than 200°C, more preferably 120°C or greater but not greater than 180°C.

After the lubricant film is formed on the inner surface of the die, the powder is filled in the heated die and pressed into a green compact under a predetermined pressure. In general, with an increase in the pressure during pressing, the green compact thus obtained has a higher density. Too high pressure however causes seizure between the inner surface of the die and the green compact or increases the ejection pressure.. When the lubricant film is formed on the inner surface of the die and warm pressing is performed, occurrence of seizure or increase in the ejection pressure can be suppressed even at an increased pressing pressure.

The pressure for obtaining a high density green compact is preferably 600 MPa or greater, more preferably 700 MPa or greater, still more preferably 1000 MPa or greater. Too high pressures decreases the life of the die. Accordingly, the pressure is preferably 2000 MPa or less, more preferably 1500 MPa or less.

The green compact thus obtained is then heat treated. If the low magnetostrictive material of the present invention is used as a dust core, a residual strain at the time of pressing, if any, causes deterioration of magnetic properties such as increase in the retention force, decrease in magnetic permeability and increase in hysteresis loss. It is therefore preferred to carry out annealing for the removal of the residual strain in order to obtain a dust core excellent in magnetic properties.

Heat treatment is performed under an inert atmosphere (for example, in an argon or vacuum). Heat treatment in an oxidizing atmosphere is not preferred, because it oxidizes the soft magnetic powder and deteriorates magnetic properties.

As the heat treatment temperature, the optimum one is selected depending on the composition of the soft magnetic powder, pressing conditions and the like so as to remove the residual strain in the green compact sufficiently. Similarly, as the heat treatment time, the optimum one is selected depending on the composition of the soft magnetic powder, heat treating temperature and the like so as to remove the residual strain in the green compact sufficiently. In general, too low heat treatment temperature and/or too short heat treatment time cannot remove the residual strain sufficiently. Too high heat treatment temperature and/or too long heat treatment time, on the other hand, causes diffusion of component elements, thereby deteriorating the magnetic properties of the green compact.

For example, the green compact made of an Fe-Si alloy and a silicon-based resin is heat treated at preferably 600°C or greater but not greater than 900°C, more preferably 650°C or greater but not greater than 850°C. The heat treatment time is typically from about 0.5 to 4 hours, though depending on the heat treatment temperature.

By use of the above-described method under the optimized manufacturing conditions, it is possible to obtain a low magnetostrictive body whose:

(1) absolute value of the magnetostriction $\lambda_{O-P}$ (1T/50Hz) is not greater than $1.0 \times 10^{-6}$,
(2) absolute value of the magnetostriction $\lambda_{O-P}$ (1T/50Hz) is not greater than $0.5 \times 10^{-6}$,
(3) absolute value of the magnetostriction $\lambda_{O-P}$ (1T/50Hz) is not greater than $0.3 \times 10^{-6}$, and/or
(4) absolute value of the magnetostriction $\lambda_{O-P}$ (1T/50Hz) is not greater than $0.2 \times 10^{-6}$.

By use of the above-described method under the optimized manufacturing conditions, it is also possible to obtain a low magnetostrictive body satisfying the following equation:

$$(1) \quad |\lambda_{O-P}/\lambda'_{O-P}(1T/50Hz)| \le 0.5,$$

$$(2) \quad |\lambda_{O-P}/\lambda'_{O-P}(1T/50Hz)| \le 0.25,$$

$$(3) \quad |\lambda_{O-P}/\lambda'_{O-P}(1T/50Hz)| \le 0.10,$$

$$(4) \quad |\lambda_{O-P}/\lambda'_{O-P}(0.5T/50Hz)| \le 0.25,$$

and/or

$$(5) \quad |\lambda_{O-P}/\lambda'_{O-P}(0.5T/50Hz)| \leq 0.10.$$

It is to be noted that $\lambda_{O-P}$ is the magnetostriction of a low magnetostrictive body under the condition of 1T/50Hz or 0.5T/50Hz, while $\lambda'_{O-P}$ is the magnetostriction of a bulk material having the same composition as that of the soft magnetic powder under the condition of 1T/5OHz or 0.5T/50Hz. The term "bulk material" means a dissolved/cast material or sintered body made of a material having the same composition as that of the soft magnetic material.

The effect of the low magnetostrictive body of the present invention and dust core using the same will next be described. Dust cores are superior in recycling efficiency to magnetic cores obtained by laminating thin plates and in addition, are known to generate vibration or noise less than a board material made of the same material. Conventional dust cores, on the other hand, have a drawback that they generate a lot of vibration or noise compared with magnetic cores using an alloy having low magnetostriction. Use of a material having low magnetostriction as a magnetic powder is therefore preferred in order to obtain a dust core excellent in recycling efficiency and quietness.

Conventionally known low magnetostrictive alloys have problems such as low saturation magnetization, low formability and high cost. An inexpensive dust core having high magnetic properties cannot therefore be manufactured using such a conventional low magnetostrictive alloy powder.

The present inventors have found that when the organic compound is added to the soft magnetic material to prepare a green compact, optimization of the kind of the organic compound leads to an increase or decrease of the magnetostriction of the green compact.. It is therefore possible to obtain a low magnetostrictive body having substantially zero magnetostriction by adding, according to the kind of the soft magnetic material, an organic compound having an effect of increasing or decreasing the magnetostriction of the soft magnetic material and optimizing the amount of the organic compound.

Details of the reason of such an effect are not known but it is presumed that when a certain organic compound is added to the soft magnetic powder and the green compact thus obtained is heat treated, decomposition products remain in the grain boundary and increase or decrease the magnetostriction.

The low magnetostrictive body of the present invention can be prepared at a low cost because it does not need an expensive low magnetostrictive alloy as a starting raw material. In addition, it is a green compact so that it is excellent in recycling efficiency. Moreover, since the low magnetostrictive body is low magnetostrictive, if it is used to obtain a dust core, then such dust core that is small in size and excellent in quietness is available.

Furthermore, use of a specific low magnetostrictive alloy as a starting raw material is not necessary for attaining low magnetostriction so that the degree of freedom of selecting a material is high. It is therefore possible to accomplish both high magnetic properties (such as high magnetic flux density, high saturation magnetization, and low loss) and low magnetostriction.

EXAMPLES

(Examples 1 to 6)

As a soft magnetic powder, a gas atomized powder or water atomized powder (from -#100 to +#350) of an Fe-Si alloy (Si content: from 1 to 3 wt%) was used. A predetermined amount (from 0.1 to 3.0 mass% based on the weight of the powder) of a commercially available silicon-based resin was diluted with ethanol and the soft magnetic powder was then added to it. They were mixed, followed by drying. The resulting powder was pressed by the die lubrication warm high-pressure forming method into a test piece used for evaluation of properties. The pressing conditions are as described below.

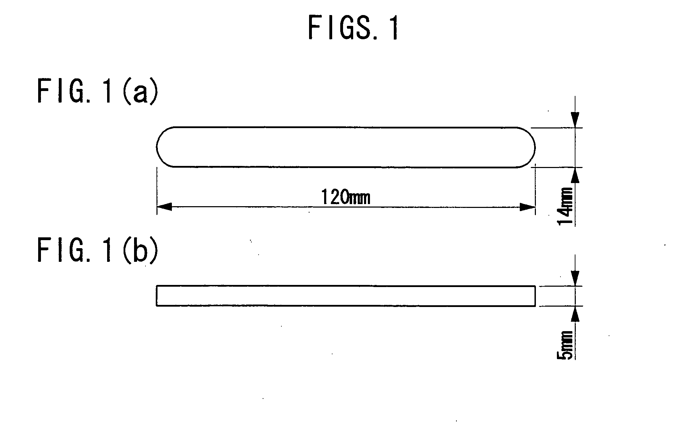

Shape of the test piece: rod-like test piece (refer to FIGS. 1) and ring-shaped test piece ($\phi 39 \times \phi 30 \times$ height: 5 mm)
Pressure: 1568 MPa
Die temperature: 150°C
Die lubricant: application of water-dispersed lithium stearate onto the surface of the die by spraying
Die: made of a die steel, heated by a band heater
Heating temperature of powder: 150°C
After pressing, the test piece thus obtained was heat treated at 750°C for 0.5 hour in an inert atmosphere.

(Comparative Examples 1 to 3)

A sintered body was prepared using the gas atomized powder made of an Fe-Si alloy used in Examples 1 to 6. From the resulting sintered body, a rod-like test piece and a ring-shaped test piece having similar shapes to those obtained in Examples 1 to 6 were prepared, respectively.

(Comparative Example 4)

A rod-like test piece and a ring-shaped test piece having similar shapes to those obtained in Examples 1 to 6 were prepared, respectively, by use of a laminated steel plate obtained by stacking Fe-6.5% Si steel plates.

(Comparative Examples 5 to 8)

Under similar conditions to those employed in Examples 1 to 6 except that the amount of the silicon-based resin was changed, test pieces for evaluation of properties were formed and then heat treated.

Magnetic properties of the test pieces obtained in Examples 1 to 6 and Comparative Examples 1 to 8 were measured. Alternating-current susceptibility was measured using an AC B-H curve tracer. Electric resistance was measured by a four probe method by means of a micro-ohm meter. Magnetostriction was determined by measuring a displacement amount in an alternating current magnetic field having a magnetic flux density of 1T or 0.5T and frequency of 50 Hz by means of a laser Doppler vibrometer.

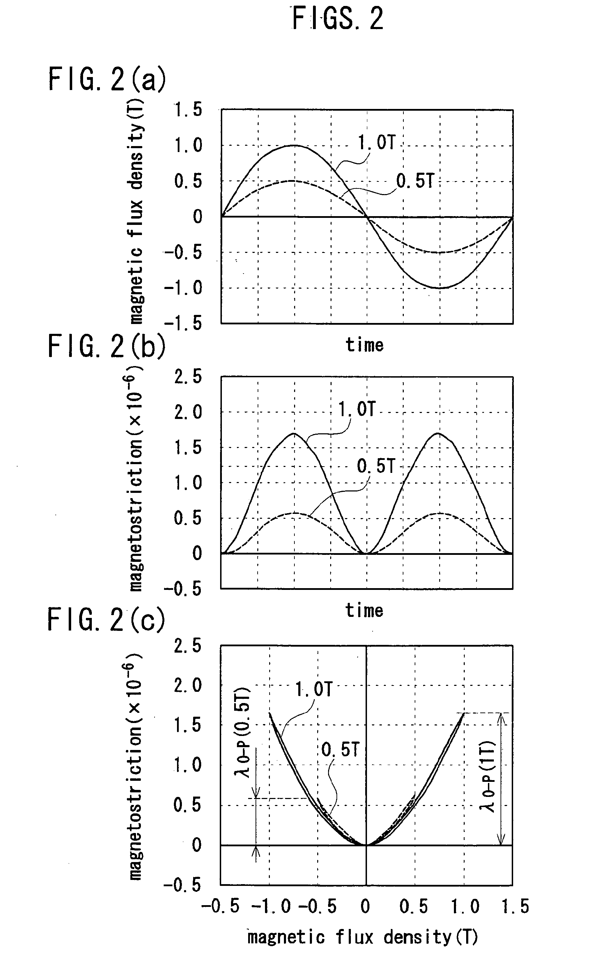

FIGS. 2 shows typical magnetostriction measurement examples (FIG. 2(a): magnetic flux density - time curve, FIG. 2 (b): magnetostriction - magnetic flux density curve, FIG. 2(c): magnetostriction - magnetic flux density curve).

Measurement results are shown in Table 1. In this Table 1, $|\lambda_{O-P}/\lambda'_{O-P}|$ represents a ratio of magnetostriction ($\lambda_{O-P}$) of each sample relative to magnetostriction ($\lambda'_{O-P}$) of the sintered material (Comparative Examples 1 to 3) having the same composition.

[Table 1]

| | Soft magnetic material | Addition amount of resin (%) | 1T/50Hz | | 0.5T/50Hz | | Magnetic flux density (T) | | Loss (0.2T/ 10kHz) (kW/m$^3$) |
|---|---|---|---|---|---|---|---|---|---|
| | | | Magneto-striction ($\times 10^{-6}$) | $\left\|\dfrac{\lambda_{0-P}}{\lambda'_{0-P}}\right\|$ | Magneto-striction ($\times 10^{-6}$) | $\left\|\dfrac{\lambda_{0-P}}{\lambda'_{0-P}}\right\|$ | $B_{10k}$ | $B_{max}$ | |
| Example 1 | 1 Si gas | 0.5 | 0.63 | 0.37 | 0.28 | 0.78 | 1.3 | 2.1 | 600 |
| Example 2 | 1 Si gas | 0.7 | -0.20 | 0.12 | 0.03 | 0.08 | 1.2 | 2.1 | 620 |
| Example 3 | 2 Si gas | 1.0 | -0.63 | 0.35 | -0.09 | 0.22 | 0.9 | 1.9 | 550 |
| Example 4 | 2 Si water | 1.0 | 0.20 | 0.11 | 0.19 | 0.46 | 1.3 | 2.0 | 650 |
| Example 5 | 3 Si gas | 1.0 | 0.17 | 0.09 | 0.11 | 0.23 | 0.8 | 1.9 | 410 |
| Example 6 | 3 Si water | 1.0 | 0.51 | 0.27 | 0.26 | 0.55 | 1.0 | 1.9- | 550 |
| Comparative Example 1 | 1 Si Sintered material | - | 1.7 | 1.0 | 0.36 | 1.0 | 1.7 | 2.2 | 5000 |
| Comparative Example 2 | 2 Si Sintered material | - | 1.8 | 1.0 | 0.41 | 1.0 | 1.7 | 2.1 | 4500 |
| Comparative Example 3 | 3 Si Sintered material | - | 1.9 | 1.0 | 0.47 | 1.0 | 1.7 | 2.1 | 4500 |
| Comparative Example 4 | 6.5% Si Laminated steel plate | - | 0.4 | - | 0.1 | - | 1.6 | 1.8 | 300 |
| Comparative Example 5 | 1 Si gas | 1.0 | -1.7 | 1.0 | -0.35 | 0.97 | 1.1 | 1.9 | 640 |
| Comparative Example 6 | 2 Si gas | 1.5 | -3.6 | 2.0 | -0.95 | 2.3 | 0.75 | 1.8 | 570 |
| Comparative Example 7 | 3 Si gas | 0.5 | 1.7 | 0.90 | 0.59 | 1.3 | 1.2 | 2.0 | 400 |
| Comparative Example 8 | 3 Si gas | 1.5 | -2.1 | 1.10 | -0.45 | 0.96 | 0.96 | 1.8 | 450 |

The Fe-6.5% Si laminated steel plate (Comparative Example 4) showed low magnetostriction and low loss. Compared with the Fe-6.5% Si laminated steel plate, the sintered materials made of an Fe-Si alloy (Comparative Examples 1 to 3) had a high magnetic flux density, but the magnetostriction of each of them under the condition of 1T/SOHz exceeded $1 \times 10^{-6}$ and their loss exceeded 10 times the loss of the Fe-6.5% Si laminated steel plate. A considerably large loss of the sintered materials owe to a large eddy current loss.
The green compacts (Examples 1 to 6, Comparative Examples 5 to 8) obtained by adding the resin to the atomized powder had a magnetic flux density substantially equal to that of the sintered materials and had a loss about 1.3 to 2.1 times the loss of the Fe-6.5% Si laminated steel plate. The magnetostriction of the green compact varied with the amount of the resin. It has been understood from Table 1 that a green compact having magnetostriction not greater than that of the Fe-6.5% Si laminated steel plate can be obtained by changing the amount of the resin.
The magnetostriction of the green compact using the water atomized powder has shifted in the positive direction compared with that using the gas atomized powder. This is because the resin amount is apparently small owing to a large specific surface area of the powder.

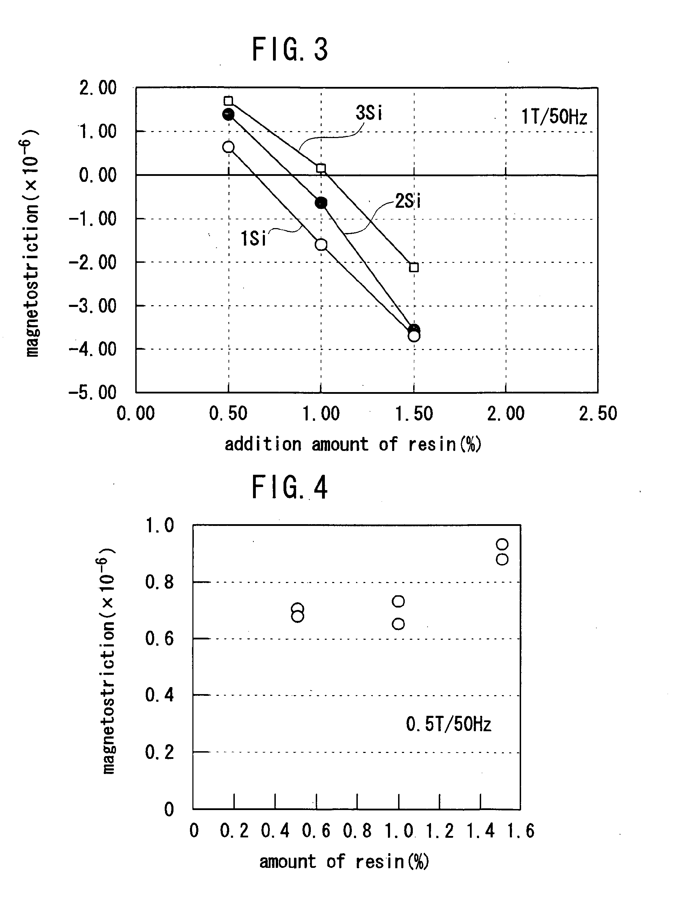

FIG. 3 shows the relationship between the amount of the resin and magnetostriction. In a gas atomized powder made of an Fe-1% Si alloy, the relationship between the amount of the resin x (wt%) and magnetostriction $\lambda_{O-P}$ in the vicinity of zero magnetostriction under the condition of 1T/50Hz is represented by the following equation (1). In accordance with the equation (1), the magnetostriction $\lambda_{O-P}$ becomes almost zero when the resin amount x is about 0.6 wt%.

$$\lambda_{O-P} = -4.32 \times 10^{-6}x + 2.73 \times 10^{-6} \qquad (1)$$

Similarly, in a gas atomized powder made of an Fe-2Si alloy, the relationship between the amount of the resin x (wt%) and magnetostriction $\lambda_{O-P}$ in the vicinity of zero magnetostriction under the condition of 1T/SOHz is represented by the following equation (2). In accordance with the equation (2), the magnetostriction $\lambda_{O-P}$ becomes almost zero when the resin amount x is about 0.8 wt%.

$$\lambda_{O-P} = -4.98 \times 10^{-6}x + 4.03 \times 10^{-6} \qquad (2)$$

Similarly, in a gas atomized powder made of an Fe-3Si alloy, the relationship between the amount of the resin x (wt%) and magnetostriction $\lambda_{O-P}$ in the vicinity of zero magnetostriction under the condition of 1T/50Hz is represented by the following equation (3). In accordance with the equation (3), the magnetostriction $\lambda_{O-P}$ becomes almost zero when the resin amount x is about 1.0 wt%.

$$\lambda_{O-P} = -3.80 \times 10^{-6}x + 3.72 \times 10^{-6} \qquad (3)$$

(Example 7)

Under similar conditions to those employed in Examples 1 to 6 except that a gas atomized powder made of an Fe-1%Si alloy was used as the soft magnetic powder and a PPS resin was used instead of the silicon-based resin, forming of a green compact and subsequent heat treatment were performed. The magnetostriction of the test piece thus obtained was measured under similar conditions to those employed in Examples 1 to 6. The relationship between the amount of the PPS resin and magnetostriction is shown in FIG. 4. It has been understood from FIG. 4 that the PPS resin used in combination with the soft magnetic powder has an effect of increasing the magnetostriction. This suggests that a low magnetostrictive body having substantially zero magnetostriction is available by use of a soft magnetic material having negative magnetostrictive properties with a PPS resin.

The embodiments of the present invention were described in detail. It should be borne in mind, however, that the present invention is not limited to or by these embodiments and various modifications can be made without departing from the scope of the present invention.

INDUSTRIAL APPLICABILITY

The low magnetostrictive body according to the present invention and dust core using the same can be used as a magnetic core of various electric appliances such as motor, transformer, DC solenoid actuator, inverter, switching device and noise filter.

BRIEF DESCRIPTION OF THE DRAWINGS

[FIGS. 1] FIG. 1(a) and FIG. 1(b) are a plan view and an elevation view of a rod-like test piece for evaluation of properties, respectively.
[FIGS. 2] FIG. 2(a) FIG. 2(b) and FIG. 2(c), are a typical magnetostriction-time curve, a flux density-time curve and a magnetostriction-flux density curve, respectively.
[FIG. 3] FIG. 3 illustrates the relationship between the amount of a silicon-based resin added to an Fe-1 to 3% Si alloy powder and magnetostriction.
[FIG. 4] FIG. 4 illustrates the relationship between the amount of a PPS resin added to an Fe-1% Si alloy powder and magnetostriction.

**Claims**

1. A low magnetostrictive body obtained by adding, to a powder composed of a soft magnetic material, an organic compound having an effect of changing a magnetostriction of the soft magnetic material when used in combination with the soft magnetic material; pressing the resulting mixture into a green compact, and then heat treating the green compact in an inert atmosphere,
wherein the absolute value of the magnetostriction $\lambda_{O\text{-}P}$ (1T/50Hz) is $1.0 \times 10^{-6}$ or less.

2. The low magnetostrictive body according to Claim 1,
wherein the absolute value of the magnetostriction $\lambda_{O\text{-}P}$ (1T/50Hz ) is $0.5 \times 10^{-6}$ or less.

3. The low magnetostrictive body according to Claim 1,
wherein

$$|\lambda_{O\text{-}P}/\lambda'_{O\text{-}P}| \leq 0.5,$$

in which, $\lambda_{O\text{-}P}$ is a magnetostriction (1T/50Hz) of the low magnetostrictive body, and $\lambda'_{O\text{-}P}$ is a magnetostriction (1T/50Hz) of a bulk material having the same composition as that of the powder.

4. The low magnetostrictive body according to Claim 1,
wherein

$$|\lambda_{O\text{-}P}/\lambda'_{O\text{-}P}| \leq 0.25,$$

in which, $\lambda_{O\text{-}P}$ is a magnetostriction (1T/50Hz) of the low magnetostrictive body, and $\lambda'_{O\text{-}P}$ is a magnetostriction (1T/50Hz) of a bulk material having the same composition as that of the powder.

5. The low magnetostrictive body according to Claim 1,
wherein

$$|\lambda_{O\text{-}P}/\lambda'_{O\text{-}P}| \leq 0.10,$$

in which, $\lambda_{O\text{-}P}$ is a magnetostriction (1T/50Hz) of the low magnetostrictive body, and $\lambda'_{O\text{-}P}$ is a magnetostriction (1T/50Hz) of a bulk material having the same composition as that of the powder.

6. The low magnetostrictive body according to Claim 1,

wherein the soft magnetic material has positive magnetostriction properties, and
the organic compound which has an effect of decreasing the magnetostriction of the soft magnetic material with an increase in its amount when used in combination with the soft magnetic material.

7. The low magnetostrictive body according to Claim 1,
wherein the soft magnetic material has negative magnetostriction properties, and
the organic compound which has an effect of increasing the magnetostriction of the soft magnetic material with an increase in its amount when used in combination with the soft magnetic material.

8. The low magnetostrictive body according to Claim 1,
wherein the soft magnetic material is a metal material having Fe as a principal component thereof.

9. The low magnetostrictive body according to Claim 1,
wherein the soft magnetic material is an Fe-Si alloy having an Si content of from 0.5 to 3.5 wt%.

10. The low magnetostrictive body according to Claim 1,
wherein the organic compound is a silicon-based resin.

11. The low magnetostrictive body according to Claim 1,
wherein the soft magnetic material is an Fe-Si alloy having an Si content of $1.0 \pm 0.2$ wt%, and
the resin is a silicon-based resin.

12. The low magnetostrictive body according to Claim 11,
wherein the soft magnetic material has an average particle size of 20 $\mu$m or greater but not greater than 200 $\mu$m, and
the amount of the resin is 0.4 wt% or greater but not greater than 0.8 wt% based on the amount of the soft magnetic material.

13. The low magnetostrictive body according to Claim 1,
wherein the soft magnetic material is an Fe-Si alloy having an Si content of $2.0 \pm 0.2$ wt%, and
the resin is a silicon-based resin.

14. The low magnetostrictive body according to Claim 13,
wherein the soft magnetic material has an average particle size of 20 $\mu$m or greater but not greater than 200 $\mu$m, and
the amount of the resin is 0.6 wt% or greater but not greater than 1.1 wt% based on the amount of the soft magnetic material.

15. The low magnetostrictive body according to Claim 1,
wherein the soft magnetic material is an Fe-Si alloy having an Si content of $3.0 \pm 0.2$ wt%, and
the resin is a silicon-based resin.

16. The low magnetostrictive body according to Claim 15,
wherein the soft magnetic material has an average particle size of 20 $\mu$m or greater but not greater than 200 $\mu$m, and
the amount of the resin is 0.7 wt% or greater but not greater than 1.3 wt% based on the amount of the soft magnetic material.

17. The dust core comprising the low magnetostrictive body according to any one of Claims 1 to 16.

FIGS. 1

FIG. 1 (a)

120mm

14mm

FIG. 1 (b)

5mm

# FIGS. 2

## FIG. 2(a)

## FIG. 2(b)

## FIG. 2(c)

## FIG. 3

Graph: magnetostriction($\times 10^{-6}$) vs addition amount of resin(%), 1T/50Hz. Curves labeled 3Si, 2Si, 1Si.

## FIG. 4

Graph: magnetostriction($\times 10^{-6}$) vs amount of resin(%), 0.5T/50Hz.

**INTERNATIONAL SEARCH REPORT**

| International application No. |
| --- |
| PCT/JP2006/310273 |

A. CLASSIFICATION OF SUBJECT MATTER
*H01F1/26*(2006.01)i, *C22C38/00*(2006.01)i, *C22C38/02*(2006.01)i, *H01F3/08*(2006.01)i, *H01F41/02*(2006.01)i

According to International Patent Classification (IPC) or to both national classification and IPC

B. FIELDS SEARCHED

Minimum documentation searched (classification system followed by classification symbols)
H01F1/26, C22C38/00, C22C38/02, H01F3/08, H01F41/02

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2004-146563 A (Matsushita Electric Industrial Co., Ltd.), 20 May, 2004 (20.05.04), Full text (Family: none) | 1-17 |
| Y | JP 2005-050918 A (Toyota Central Research And Development Laboratories, Inc.), 24 February, 2005 (24.02.05), Full text (Family: none) | 1-17 |
| A | JP 2000-144347 A (Alps Electric Co., Ltd.), 26 May, 2000 (26.05.00), Par. Nos. [0016], [0018] (Family: none) | 1-8,17 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 09 August, 2006 (09.08.06) | 22 August, 2006 (22.08.06) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

| | INTERNATIONAL SEARCH REPORT | International application No. |
|---|---|---|
| | | PCT/JP2006/310273 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 58-025449 A  (Tokyo Shibaura Electric Co., Ltd.), 15 February, 1983 (15.02.83), Full text (Family: none) | 1 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000030924 A
- JP 2000223308 A
- JP 2002064027 A